(19) Europäisches Patentamt / European Patent Office / Office européen des brevets

(11) **EP 3 824 549 B1**

(12) **FASCICULE DE BREVET EUROPEEN**

(45) Date de publication et mention de la délivrance du brevet:
**03.08.2022 Bulletin 2022/31**

(21) Numéro de dépôt: **19739308.5**

(22) Date de dépôt: **17.07.2019**

(51) Classification Internationale des Brevets (IPC):
*H03F 3/217* (2006.01)   *H03F 3/193* (2006.01)
*H03F 3/24* (2006.01)   *H04L 25/49* (2006.01)
*H04B 1/04* (2006.01)

(52) Classification Coopérative des Brevets (CPC):
**H03F 3/2173; H03F 3/193; H03F 3/245;
H04L 25/4902;** H03F 2200/351; H03F 2200/451;
H04B 2001/045

(86) Numéro de dépôt international:
**PCT/EP2019/069258**

(87) Numéro de publication internationale:
**WO 2020/016305 (23.01.2020 Gazette 2020/04)**

(54) **ARCHITECTURE EMETTRICE RADIOFREQUENCE RF**

ARCHITEKTUR FÜR HF-FUNKFREQUENZSENDER

RF RADIO FREQUENCY TRANSMITTER ARCHITECTURE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.07.2018 FR 1800778**

(43) Date de publication de la demande:
**26.05.2021 Bulletin 2021/21**

(73) Titulaire: **THALES
92400 Courbevoie (FR)**

(72) Inventeurs:
• **DEMENITROUX, Wilfried
49309 CHOLET (FR)**
• **MANDICA, Lucas
49309 CHOLET (FR)**
• **ALBERT, Dilan
49309 CHOLET (FR)**

(74) Mandataire: **Marks & Clerk France
Immeuble "Visium"
22, avenue Aristide Briand
94117 Arcueil Cedex (FR)**

(56) Documents cités:
**EP-A1- 2 670 101   WO-A1-2008/051127
US-A1- 2017 230 017**

EP 3 824 549 B1

## Description

L'invention concerne un émetteur ou une architecture émettrice de signaux radiofréquences RF.

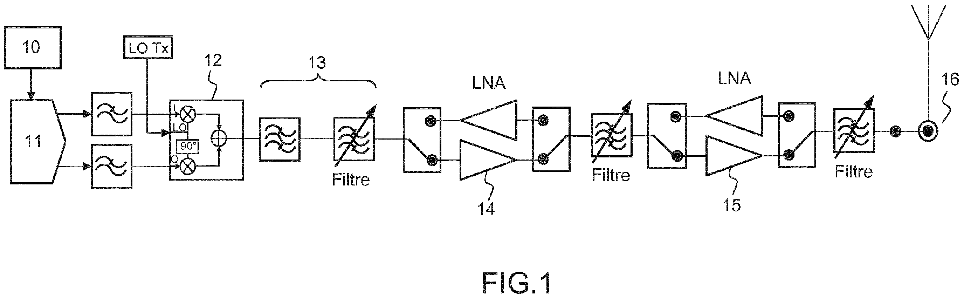

Les émetteurs/récepteurs dans le domaine de la radiofréquence RF comportent une partie émettrice telle que décrite à la figure 1.

La partie émettrice comprend un circuit logique programmable de type FPGA (Field Programmable Gate Array), 10, ayant notamment pour fonction de transmettre les échantillons décrivant le signal numérique en bande de base (centré autour de zéro) à un convertisseur numérique analogique ou CNA, 11. Le signal bande de base analogique est alors transposé à une fréquence RF grâce à un modulateur IQ, 12, étant donné l'intégration de modulations numériques dans les radios logicielles. Le signal RF est ensuite filtré 13 et amplifié afin d'optimiser la linéarité et la chaîne de gain. Enfin, pour des applications impliquant des signaux de forts niveaux, le signal RF est amplifié en utilisant des étages de puissance, tels que des préamplificateurs ou « pre-drivers » non représentés sur la figure 1, des amplificateurs de puissances « driver », 14 et « boosters », 15. Suivant la puissance désirée en sortie d'antenne, on bipassera ou non les étages de transistors.

Cette solution présente au moins deux inconvénients sur le plan de la consommation et du bruit émis.

En effet, tous les étages de puissance de l'émetteur/récepteur (Driver Booster et parfois Pre-Driver) sont utilisés en zone linéaire, ce qui limite grandement leur rendement : ce dernier étant le rapport entre la puissance émise et la puissance fournie. Pour satisfaire les besoins en linéarité du système complet, il faut s'assurer de ne pas saturer les étages d'amplification et donc, du recul en puissance doit être pris. Cette marge par rapport à la puissance de compression de l'ampli implique un rendement plus faible ($\approx$25%).

La transposition du signal bande de base vers la fréquence RF (modulateur) ainsi que les éléments radio de la chaîne (amplificateurs, filtrage) contribuent à l'élévation de bruit en pied de porteuse, ce qui complique l'utilisation cosite. Avec les brouilleurs qui peuvent se retrouver également dans la bande utile, il devient donc primordial de rajouter des filtres passe-bande permettant une réjection importante de ces signaux et une diminution du bruit, impliquant en contrepartie beaucoup de pertes à chaque étage d'amplification.

Le document US2017/230017 décrit un amplificateur de commutation pourvu, au minimum: d'un premier transistor d'entrée recevant un des deux signaux d'entrée fonctionnant de manière complémentaire; un premier transistor cascade connecté en cascade entre le premier transistor d'entrée et une alimentation; un second transistor d'entrée recevant un des deux signaux d'entrée; et un second transistor cascade connecté en cascade entre le second transistor d'entrée et le premier transistor d'entrée; l'amplificateur de commutation extrayant un signal de sortie, un point de connexion entre le premier transistor d'entrée et le second transistor cascade étant utilisé comme borne de sortie; dans lequel un premier circuit de limitation de potentiel et un second circuit de limitation de potentiel destinés à limiter la plage de fluctuation de potentiel sont respectivement connectés à la borne d'entrée du premier transistor cascade et à la borne d'entrée du second transistor cascade.

Le document EP 2670101 divulgue un procédé de modulation de largeur d'impulsion.

Le document WO 2008/051127 divulgue une modulation de commutation d'un amplificateur de puissance radiofréquence.

L'idée de la présente invention est d'offrir une architecture émettrice de signaux RF qui résout ou minimise au moins les problèmes cités précédemment. Pour cela, des transistors de puissance seront utilisés comme des interrupteurs en mode bloqué/saturé, alors que l'art antérieur utilise ces transistors en mode linéaire. L'un des avantages de la nouvelle architecture réside dans le fait que les pertes, soit la dissipation de puissance et donc le rendement, interviennent uniquement lors de la commutation des transistors en mode saturé ou en mode passant.

Définitions et acronymes utilisés dans la description

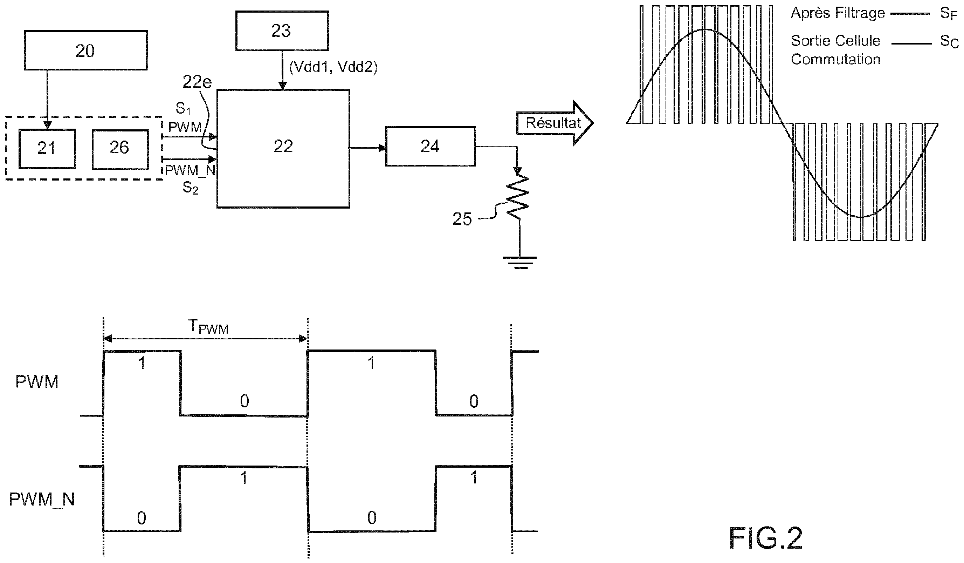

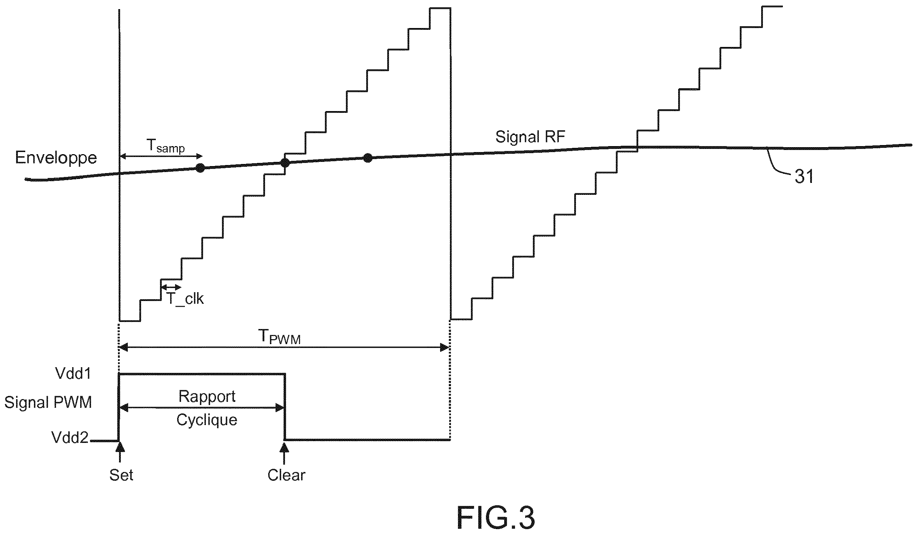

PDL : ligne à retard programmable acronyme anglo-saxon de Programmable Delay Line,
Etat interdit des entrées d'un module numérique (le module numérique pouvant être une bascule, Look-Up Table LUT...) : état qui conduit à une instabilité numérique,
« Dominance » d'un signal : priorité d'un signal par rapport à un autre. Si les entrées d'un système numérique prennent des valeurs interdites (état interdit des entrées pouvant conduire à une instabilité numérique, c'est-à-dire valeur de la sortie non fixée), la dominance d'un signal permet de fixer la valeur de sortie.
FPGA : circuit logique programmable, acronyme anglo-saxon de Field Programmable Gate Array,
PWM: signal à modulation de largeur d'impulsion, en anglo-saxon Pulse Width Modulation dont un exemple est représenté en figures 2 et 3. Le signal PWM, ici, a la caractéristique d'être un signal à fréquence fixe mais son rapport cyclique est variable.

Le terme cellule désigne une cellule de commutation d'architecture spécifique détaillée ci-après.

L'invention concerne une architecture émettrice de signaux radiofréquences RF comportant au moins une cellule de commutation commandée par un premier signal $S_1$ à modulation de largeur d'impulsion PWM et un deuxième signal $S_2$ à modulation de largeur d'impulsion PWM_N complémentaire du premier, comportant au moins les éléments suivants :

La cellule de commutation est composée d'une première cellule de commutation haute et d'une deuxième cellule de commutation basse, lesdites première et deuxième cellule sont montées en demi-pont et reliées en un point milieu M,

La première cellule de commutation haute reçoit sur une de ses entrées le premier signal $S_1$,

La deuxième cellule de commutation basse reçoit sur une de ses entrées le signal $S_2$ complémentaire au signal $S_1$,

Les signaux $S_1$ et $S_2$ sont complémentaires afin qu'une seule des deux cellules soit activée à la fois, l'une rendue passante et l'autre est bloquée,

Un dispositif d'alimentation fournissant une première valeur d'alimentation $V_{dd1}$ pour la cellule haute et une deuxième valeur d'alimentation $V_{dd2}$ pour la cellule basse ;

L'architecture est caractérisée en ce qu'elle comporte au moins :

Un dispositif de génération des deux signaux de commande de la cellule

Un premier dispositif de génération du premier signal $S_1$ comprenant au moins :

- Une première entrée pour un signal set mettant à « 1 » la sortie $S_1$,
- Une deuxième entrée pour un signal reset mettant à « 0 » la sortie $S_1$,
- Une troisième entrée pour un signal set_or_clear, choisi de façon telle que la sortie $S_1$ est à une valeur stable lorsque le signal set et le signal reset sont positionnés dans des états interdits,
- Une quatrième entrée image de la sortie du dispositif de génération du signal $S_1$,

Un deuxième dispositif de génération du deuxième signal $S_2$ comprenant au moins :

- Une première entrée pour un signal set de mise à « 1 » de sa sortie $S_2$,
- Une deuxième entrée pour un signal reset de mise à « 0 » de sa sortie $S_2$,
- Une troisième entrée pour un signal set_or_clear, choisi de façon telle que la sortie $S_2$ est à une valeur stable égale à l'inverse de la valeur du signal en sortie du premier dispositif générant le signal $S_1$ lorsque le signal set et le signal reset sont positionnés dans des états interdits,
- Une quatrième entrée image de la sortie du deuxième dispositif de génération du signal $S_2$.

La cellule peut comporter en plus un dispositif d'adaptation situé en entrée de la cellule de commutation afin d'adapter les deux signaux complémentaires.

Selon un mode de réalisation, la valeur de la tension $V_{dd2}$ est inférieure à $V_{dd1}$. Selon un autre mode de réalisation la valeur de la tension $V_{dd2}$ est égale à zéro.

Le dispositif de génération des signaux de commande peut être réalisé dans un circuit logique programmable FPGA.

L'architecture peut comporter en plus une ou plusieurs lignes de retards temporels PDL afin d'augmenter la résolution temporelle du signal PWM.

D'autres caractéristiques et avantages de la présente invention apparaîtront mieux à la lecture de la description d'exemples de réalisation annexée des figures qui représentent :

- Figure 1, un exemple d'architecture selon l'art antérieur,
- Figure 2, un schéma bloc d'un émetteur de signal RF comprenant la cellule selon l'invention,
- Figure 3, un schéma décrivant la génération du signal PWM,
- Figure 4, un exemple d'architecture numérique pour la génération des signaux $S_1$ et $S_2$,
- Figure 5, une illustration de l'affinement du rapport cyclique de la PWM, et
- Figure 6, un exemple détaillé de la cellule de commutation.

La figure 2 illustre un exemple d'architecture émettrice selon l'invention. Un diagramme ou « pattern » d'échantillons décrivant le signal RF modulé, est généré au moyen d'un ordinateur, PC, ou de tout autre dispositif équivalent. La fréquence d'échantillonnage est fonction de la fréquence du signal RF et de l'enveloppe de la modulation. Elle doit aussi respecter au minimum le critère de Nyquist. Ces échantillons sont transmis, via une liaison Ethernet, par exemple, sous un protocole de datagramme utilisateur ou UDP (User Data Protocol) ou tout autre moyen équivalent, à un dispositif programmable de type FPGA. Le FPGA 21 a notamment pour fonction de générer deux signaux de commande d'une cellule de commutation, les deux signaux sont parfaitement complémentaires : un premier signal PWM et un deuxième signal PWM_N complémentaire au premier (figure 2). La manière de générer les deux signaux complémentaires est détaillée ci-après (la génération d'un signal PWM est décrite plus loin en figure 3).

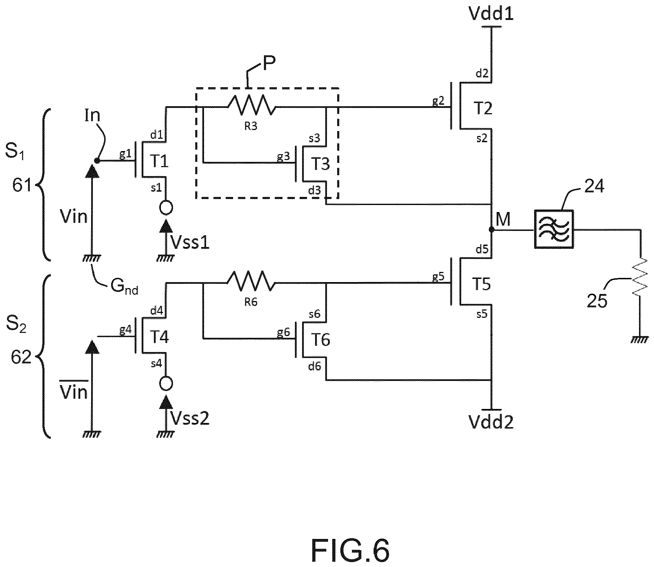

Les deux signaux complémentaires $S_1$ PWM et $S_2$ PWM_N vont commander une cellule de commutation 22 dont un exemple détaillé de structure est donné à la figure 6. La cellule de commutation 22 est alimentée par une carte d'alimentation 23 fournissant une tension haute $V_{dd1}$ et une tension basse $V_{dd2}$. En fonction de la valeur choisie pour ces alimentations, le dispositif selon l'invention pourra être utilisé en classe D ou en mode « suivi d'enveloppe » connu sous l'expression anglo-saxonne « Envelop Tracking ». Quel que soit le mode de fonctionnement, les valeurs des alimentations doivent vérifier la condition suivante $V_{dd2}<V_{dd1}$. En mode de fonctionnement classe D, la tension $V_{dd2}$ est égale à 0 Volt. La carte d'alimentation fournit aussi des tensions auxiliaires négatives $V_{SS1}$ et $V_{SS2}$ et un signal de commande (Enable). Une seule cellule sera commutée passante à la fois et l'autre cellule bloquée par conséquent. Cela signifie qu'une des deux tensions est présente sur le nœud M de sortie du montage en demi-pont (figure 6). La commutation ON d'une cellule et donc le blocage de l'autre est assurée par la complémentarité des deux signaux de commande $S_1$ et $S_2$.

En sortie de la cellule de commutation, les signaux ont une forme carrée. Afin de retrouver le signal d'entrée, un filtre passe-bas 24 est connecté sur le nœud de sortie de la cellule de commutation, point milieu M. Les répliques du signal autour de la fréquence PWM ainsi que ses multiples vont ainsi être filtrés et seul le signal à la fréquence RF désirée est conservé. Ce filtre réalise également l'adaptation d'entrée des transistors de la cellule de commutation (figure 6).

Suivant la puissance que l'on cherche à émettre sur l'antenne 25, on présentera une charge adéquate RL, selon l'application visée et les règles connues de l'homme du métier.

Un circuit d'adaptation 26 de la commande sera positionné en entrée de la cellule de commutation de façon à adapter les deux signaux de commande complémentaires. Les deux signaux de commande doivent être inversés et décalés ou « offsetés » afin de pouvoir commander les transistors normalement conducteur (ou à déplétion) ou « normally-ON » de la cellule de commutation.

Sur la figure 2 sont aussi représentés le signal $S_C$ en sortie de la cellule de commutation et le signal $S_F$ en sortie du filtre passe-bas juste avant l'antenne.

La figure 3 illustre la génération d'un signal PWM par le circuit programmable FPGA. Le signal RF analogique que l'on cherche à générer, désigné par « enveloppe » 31, est transmis au FPGA sous forme d'échantillons temporels. En pratique, la période des échantillons, désignée $T_{samp}$ sur la figure 3, est plus élevée que la période PWM, on parle d'une PWM sur-échantillonnée (sur l'illustration de la figure 3, x4). Au début de la période PWM, le signal PWM est mis à « 1 » (Set) ; ce signal est maintenu à « 1 » tant que la valeur de la rampe n'a pas atteint la valeur de l'échantillon courant (comparaison avec la rampe échelonnée). Dès lors que ce niveau est atteint, le signal de commande PWM change d'état et est mis à « 0 » (clear). Cette comparaison est reproduite pour chaque période PWM. Enfin, la durée de Set définit le rapport cyclique.

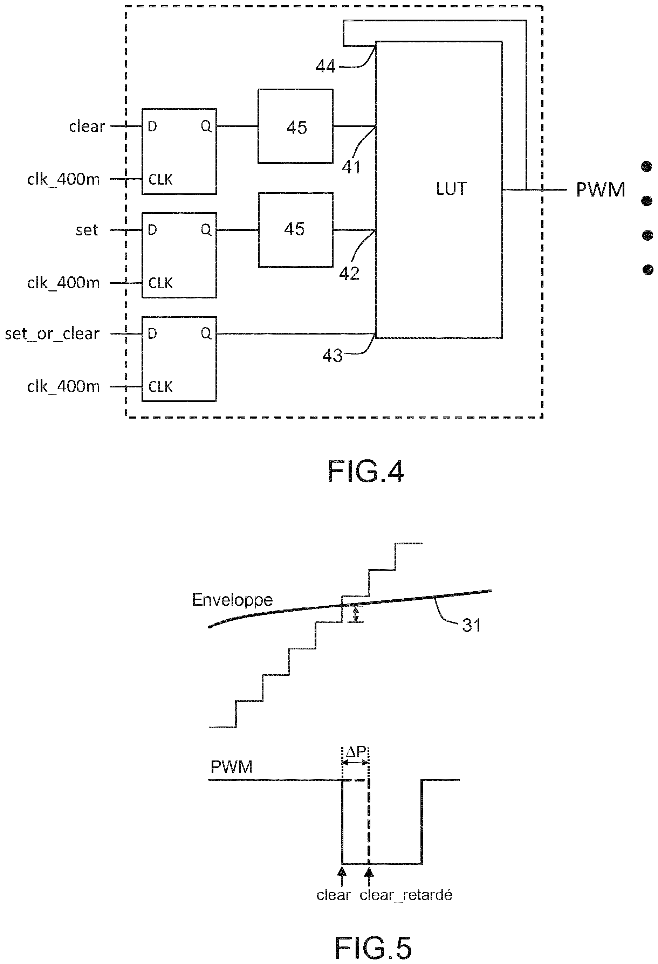

La figure 4 représente un exemple d'architecture pour la génération des deux signaux de commande complémentaires (à base de table de correspondance ou LUT) implémentée dans un FPGA.

Le signal PWM est généré à l'aide d'une table de correspondance ou « Lookup Table », LUT, à quatre entrées ayant respectivement les rôles suivants :

Entrée 41 - Un signal « set » permet de positionner à « 1 » la sortie, le signal PWM;
Entrée 42 - Le signal « clear » permet de positionner à « 0 » la sortie ou signal PWM;
Entrée 43 additionnelle - Le signal « set_or_clear » permet de déterminer la « dominance » du signal « set » ou du signal « clear », dans le cas où ces deux signaux seraient à « 1 » en même temps. En effet, une mise à « 1 » de ces deux signaux en même temps entraînerait une instabilité numérique ; Entrée 44 - La quatrième entrée correspond à un rebouclage de la sortie PWM, afin de garder son état précédent dans le cas où les signaux « set » ou « clear » sont à 0.

Par rapport à une bascule RS classique, la table utilisée dans la présente invention comporte une entrée additionnelle, signal set_or_clear, qui permet dans un état interdit des entrées set=1 et clear=1 (état qui conduit à une instabilité numérique) de fixer une valeur stable en sortie correspondant au signal set_or_clear.

Un exemple de table de correspondance est donné ci-après.

Pour la génération du signal PWM

| ENTREES | | | | SORTIE | |
|---|---|---|---|---|---|
| Set | Clear | set_or_clear | rebouclage_PWM | Sortie PWM | Commentaires |
| 0 | 0 | 0 | 0 | **0** | La sortie recopie l'entrée rebouclage_PWM |
| 0 | 0 | 0 | 1 | **1** | |
| 0 | 0 | 1 | 0 | **0** | |
| 0 | 0 | 1 | 1 | **1** | |
| 0 | 1 | 0 | 0 | **0** | Clear: Mise à 0 de la sortie |
| 0 | 1 | 0 | 1 | | |
| 0 | 1 | 1 | 0 | | |
| 0 | 1 | 1 | 1 | | |
| 1 | 0 | 0 | 0 | **1** | Set: Mise à 1 de la sortie |
| 1 | 0 | 0 | 1 | | |
| 1 | 0 | 1 | 0 | | |
| 1 | 0 | 1 | 1 | | |
| 1 | 1 | 0 | 0 | **0** | Quelle que soit la valeur du rebouclage_PWM, le signal set_or_clear prédomine --> la sortie recopie donc l'état de l'entrée set_or_clear |
| 1 | 1 | 0 | 1 | | |
| 1 | 1 | 1 | 0 | **1** | |
| 1 | 1 | 1 | 1 | | |

Pour la génération du signal complémentaire PWM N :

| ENTREES | | | | SORTIE | |
|---|---|---|---|---|---|
| Set | Clear | set_or_clear | rebouclage_PWM | Sortie PWM | Commentaires |
| 0 | 0 | 0 | 0 | **0** | La sortie recopie l'entrée rebouclage_PWM |
| 0 | 0 | 0 | 1 | **1** | |
| 0 | 0 | 1 | 0 | **0** | |
| 0 | 0 | 1 | 1 | **1** | |
| 0 | 1 | 0 | 0 | **1** | Clear: Mise à 1 de la sortie (logique inversée par rapport à la génération du PWM) |
| 0 | 1 | 0 | 1 | | |
| 0 | 1 | 1 | 0 | | |
| 0 | 1 | 1 | 1 | | |
| 1 | 0 | 0 | 0 | **0** | Set: Mise à 0 de la sortie (idem) |
| 1 | 0 | 0 | 1 | | |
| 1 | 0 | 1 | 0 | | |
| 1 | 0 | 1 | 1 | | |

(suite)

| ENTREES | | | | SORTIE | |
|---|---|---|---|---|---|
| Set | Clear | set_or_clear | rebouclage_PWM | Sortie PWM | Commentaires |
| 1 | 1 | 0 | 0 | **1** | Quelle que soit la valeur du rebouclage_PWM, le signal set_or_clear prédomine (et logique inversée) |
| 1 | 1 | 0 | 1 | | |
| 1 | 1 | 1 | 0 | **0** | |
| 1 | 1 | 1 | 1 | | |

Selon un mode de réalisation, il est possible d'améliorer la résolution du signal PWM, en utilisant des lignes à retard programmables PDL, 45.

La linéarité ainsi que la dynamique de sortie étant dépendantes de la résolution du signal PWM, il faut s'assurer d'avoir une résolution temporelle très fine. A partir de l'horloge principale du FPGA Freq_clk = 400MHz est généré un nombre de niveaux N = Freq_clk / Freq_PWM = 400/25 = 16 (chaque niveau ou « step » dure T_clk = 2,5ns), où Freq_PWM est la fréquence ou inverse de la période du signal PWM.

Si on veut augmenter la résolution temporelle du signal PWM (ce qui revient à augmenter le nombre de niveaux N), la fréquence de l'horloge principale doit être augmentée. Cependant, pour des raisons d'implémentations et de design, il est difficile de générer des fréquences d'horloge plus importantes et « propres ». Pour y remédier, il faut avoir recours à des « retards temporels », cette fonction étant remplie par les blocs PDL (Programmable Delay Line), 45 (figure 4). Ces blocs PDL permettent de régler plus finement le rapport cyclique en agissant sur le signal « clear » (front descendant du signal PWM) en le décalant dans le temps par pas très fins $\Delta P$, figure 5. Cependant, pour éviter un déséquilibre de temps de propagation entre le chemin du signal « set » et celui du signal « clear », on ajoute également un bloc PDL (45 figure 4) sur le chemin du signal « set ». Ce dernier sera configuré avec un décalage de « 0 ».

Dans l'exemple donné pour illustrer l'invention, les blocs PDL sont des blocs configurables pouvant monter jusqu'à 512 pas, chaque pas permettant de décaler le signal d'environ 5ps. Ainsi, l'intervalle de décalage possible pour le signal « clear » est compris entre 0 et 512*5ps = 2,56 ns, ce qui est suffisant car il permet de couvrir une période entière de Freq_clk.

La figure 6 détaille un exemple d'architecture pour la cellule de commutation 22 comprenant, par exemple, une première cellule haute 61 et une deuxième cellule basse 62, montées en demi-pont, afin de commuter alternativement les tensions $V_{dd1}$ et $V_{dd2}$ sur le nœud M de sortie de la cellule de commutation.

Partie supérieure de la figure - cellule haute 61

La structure de base de la partie supérieure ou cellule haute 61 comprend :

- un port d'entrée In qui reçoit un signal d'entrée $V_{in}$ référencé par rapport à la masse générale de la cellule Gnd (0 volt) et qui commande la commutation de la cellule à l'état ON ou OFF ;
- un transistor d'entrée $T_1$, dont la grille $g_1$ est connectée au port d'entrée In de la cellule et dont la source est référencée à $V_{ss1}$, qui peut être la masse ou une valeur négative;
- un transistor de puissance $T_2$, de type normalement conducteur ("Normally ON") dont le drain $d_2$ reçoit la tension d'alimentation positive $V_{dd1}$ pour l'appliquer sur le port de sortie Out de la cellule haute, la source $s_2$ de ce transistor étant connectée au port de sortie Out ou point milieu du montage demi-pont des deux cellules basse et haute ;
- un circuit d'auto-polarisation de grille qui comprend :
- un transistor $T_3$ qui est un transistor à effet de champ de type normalement conducteur, connecté comme suit : son drain $d_3$ est relié à la source $s_2$ du transistor de puissance $T_2$ et donc au plot de sortie Out (point milieu M) de la cellule ; sa source $s_3$ est reliée à la grille $g_2$ ; sa grille $g_3$ est reliée à la résistance $R_3$ ; et
- une résistance d'auto-polarisation $R_3$ de la grille $g_3$ du transistor $T_3$, connectée entre cette grille $g_3$ et la source $s_3$ du transistor $T_3$, et en série avec le drain du premier transistor $T_1$.

Une résistance sur le drain du transistor $T_1$, présente dans la cellule antérieure, n'est pas représentée ici. Elle est optionnelle.

L'ensemble formé par le circuit d'auto-polarisation P et le transistor de puissance $T_2$ constitue la charge du transistor d'entrée $T_1$, charge qui est ainsi placée en série entre le drain $d_1$ du transistor $T_1$ et la tension d'alimentation positive $V_{dd1}$.

On notera que dans cette structure, le transistor $T_3$ est comme le transistor $T_2$, un transistor à source flottante, au sens que sa source $s_3$ n'est pas référencée à un potentiel fixe : elle suit la tension de grille du transistor de puissance $T_2$.

Le fonctionnement de la cellule haute va maintenant être expliqué, en considérant une charge purement résistive de sortie, notée RL.

La cellule de commutation a deux états stables, les états ON et OFF :

○ la cellule est dite à l'état ON lorsque les transistors $T_2$ et $T_3$ sont passants (état ON), et que la structure délivre de la puissance à la charge en appliquant l'alimentation principale $V_{dd1}$ sur cette dernière ;

○ la cellule est dite à l'état OFF lorsque les transistors $T_2$ et $T_3$ sont à la limite du blocage (état OFF) et que la charge est isolée de l'alimentation principale $V_{dd1}$.

Les transistors $T_3$ et $T_2$ sont commandés à l'état On, passant, ou OFF, bloqué, en fonction du signal de commande $V_{in}$ appliqué en entrée In de la cellule, et qui commande l'état ON ou OFF du transistor $T_1$.

Partie inférieure - cellule basse 62

Le fonctionnement de la cellule basse 62 est identique à celui de la cellule haute à la différence que c'est la tension $V_{dd2}$ qui est appliquée à la charge quand la cellule basse est à l'état ON. Pour rappel, la commande ON d'une cellule implique l'état OFF de l'autre par la nature complémentaire des signaux de commande.

La structure de base de la partie inférieure ou cellule basse 62 comprend :

- un port d'entrée In qui reçoit un signal d'entrée $\overline{V_{in}}$ référencé par rapport à la masse générale de la cellule Gnd (0 volt) et qui commande la commutation de la cellule à l'état ON ou OFF ;
- un transistor d'entrée $T_4$, dont la grille $g_4$ est connectée au port d'entrée In de la cellule et dont la source $s_4$ est référencée à $V_{ss2}$, qui peut être la masse ou une valeur négative;
- un transistor de puissance $T_5$, de type normalement conducteur ("Normally ON") dont le drain $d_5$ est connecté au port de sortie Out au point milieu, la source $s_5$ de ce transistor étant connectée à la tension $V_{dd2}$;
- un circuit d'auto-polarisation P de grille qui comprend :
- un transistor $T_6$ qui est un transistor à effet de champ de type normalement conducteur, connecté comme suit : son drain $d_6$ est relié à la tension $V_{dd2}$ ; sa source $s_6$ est reliée à la grille $g_5$ ; sa grille $g_6$ est reliée à la résistance $R_6$; et

  - une résistance d'auto-polarisation $R_6$ de la grille $g_6$ du transistor $T_6$, connectée entre cette grille $g_6$ et la source $s_6$ du transistor $T_6$, et en série avec le drain du premier transistor $T_4$.

La cellule basse 61 ou la cellule haute 62 peuvent présenter une architecture telle que celle décrite dans le brevet EP3134972.

L'ensemble formé par le circuit d'auto-polarisation P et le transistor de puissance $T_5$ constitue la charge du transistor d'entrée $T_4$, charge qui est ainsi placée en série entre le drain $d_4$ du transistor $T_4$ et la tension d'alimentation positive $V_{dd2}$.

On notera que dans cette structure, le transistor $T_6$ est un transistor à source flottante, au sens que sa source $s_6$ n'est pas référencée à un potentiel fixe : elle suit la tension de grille du transistor de puissance $T_5$.

Le fonctionnement de la cellule basse va maintenant être expliqué, en considérant une charge purement résistive de sortie, notée RL (ou antenne 25).

La cellule de commutation a deux états stables, les états ON et OFF :

○ la cellule est dite à l'état ON lorsque les transistors $T_5$ et $T_6$ sont passants (état ON), et la structure délivre de la puissance à la charge en appliquant $V_{dd1}$ sur cette dernière ;

○ la cellule est dite à l'état OFF lorsque les transistors $T_5$ et $T_6$ sont à la limite du blocage (état OFF) et la charge est isolée de l'alimentation principale.

Les transistors $T_6$ et $T_5$ sont commandés à l'état On, passant ou OFF, bloqué, en fonction du signal de commande $V_{in}$ appliqué en entrée In de la cellule, et qui commande l'état ON ou OFF du transistor $T_4$.

Point de jonction entre les deux cellules - montage demi-pont

La demi-cellule haute 61 et la demi-cellule basse 62 sont reliées à un point de sortie (ou point milieu M). Pour cela, la source $s_2$ du transistor $T_2$ de la cellule haute est reliée au drain $d_5$ du transistor $T_5$ de la cellule basse. La sortie M est reliée au filtre passe-bas, lui-même relié à l'antenne.

L'architecture selon l'invention présente notamment comme avantages de réduire la consommation à puissance maximale (porteuse non modulée), et de conserver un rendement élevé quasi-identique pour des modulations à fort rapport entre la puissance moyenne et la crête ou PAPR (Peak to Average Power Ratio). De plus, le bruit émis par ce genre de structure est bien meilleur qu'une transposition classique.

La dissipation de puissance et donc la performance de rendement interviennent uniquement lors de la commutation des transistors en mode passant (ou saturé OFF→ON). L'architecture permet d'obtenir des rendements très importants supérieurs à 90% pour des émissions à forts niveaux (plusieurs dizaines de watts).

**Revendications**

**1.** - Architecture émettrice de signaux radiofréquences RF comportant au moins une cellule de commutation (22) commandée par un premier signal $S_1$ à modulation de largeur d'impulsion PWM et un deuxième signal $S_2$ à modulation de largeur d'impulsion PWM_N complémentaire du premier, comportant au moins les éléments suivants :

La cellule de commutation (22) est composée d'une première cellule de commutation haute (61) et d'une deuxième cellule de commutation basse (62), lesdites première et deuxième cellule sont montées en demi-pont et reliées en un point milieu M,
La première cellule de commutation haute (61) est configurée pour recevoir sur une de ses entrées le premier signal $S_1$,
La deuxième cellule de commutation basse est configurée pour recevoir sur une de ses entrées le signal $S_2$ complémentaire au signal $S_1$,
Les signaux $S_1$ et $S_2$ sont complémentaires afin qu'une seule des deux cellules soit rendue passante et l'autre bloquée,
Un dispositif d'alimentation (23) est configuré pour fournir une première valeur d'alimentation $V_{dd1}$ pour la cellule haute (61) et une deuxième valeur d'alimentation $V_{dd2}$ pour la cellule basse (62), et **caractérisée en ce qu'**elle comporte au moins :

Un dispositif (21) de génération des deux signaux de commande de la cellule Un premier dispositif de génération du premier signal $S_1$ comprenant au moins :

- Une première entrée (41) pour un signal set de mise à « 1 » de sa sortie $S_1$,
- Une deuxième entrée (42) pour un signal reset de mise à « 0 » de sa sortie $S_1$,
- Une troisième entrée (43) pour un signal set_or_clear, choisi de façon telle que la sortie $S_1$ est à une valeur stable lorsque le signal set et le signal reset sont positionnés dans des états interdits,
- Une quatrième entrée (44) image de la sortie du dispositif de génération du signal $S_1$,

Un deuxième dispositif de génération du deuxième signal $S_2$ comprenant au moins :

- Une première entrée (41) pour un signal set de mise à « 1 » de sa sortie $S_2$,
- Une deuxième entrée (42) pour un signal reset de mise à « 0 » de sa sortie $S_2$,
- Une troisième entrée (43) pour un signal set_or_clear, choisie de façon telle que la sortie $S_2$ est à une valeur stable égale à l'inverse de la valeur du signal en sortie du premier dispositif générant le signal $S_1$ lorsque le signal set et le signal reset sont positionnés dans des états interdits,
- Une quatrième entrée (44) image de la sortie du deuxième dispositif de génération du signal $S_2$.

**2.** - Architecture émettrice de signaux RF selon la revendication 1 **caractérisée en ce qu'**elle comporte en plus un dispositif d'adaptation (26) situé en entrée de la cellule de commutation afin d'adapter les deux signaux complémentaires.

**3.** - Architecture émettrice de signaux RF selon l'une des revendications 1 ou 2 **caractérisée en ce que** la valeur de la tension $V_{dd2}$ est inférieure à $V_{dd1}$.

**4.** - Architecture émettrice de signaux RF selon l'une des revendications 1 ou 2 **caractérisée en ce que** la valeur de la tension $V_{dd2}$ est égale à zéro.

**5.** - Architecture émettrice de signaux RF selon l'une des revendications 1 ou 2 **caractérisée en ce que** le dispositif (21) de génération des signaux de commande est réalisé dans un circuit logique programmable FPGA.

6.  - Architecture émettrice de signaux RF selon la revendication 5 **caractérisée en ce que** le circuit logique programmable comprend une table de correspondance à quatre entrées ayant respectivement les rôles suivants :

Un signal « set » permet de positionner à « 1 » la sortie, le signal PWM;
Un signal « clear » permet de positionner à « 0 » la sortie ou signal PWM;
Un signal « set_or_clear » permet de déterminer la « dominance » du signal « set » ou du signal « clear », dans
le cas où ces deux signaux seraient à « 1 » en même temps,
Un rebouclage de la sortie PWM, afin de garder son état précédent dans le cas où les signaux « set » ou
« clear » sont à 0,
La table de correspondance est configurée pour générer le signal PWM et le signal complémentaire PWM_N,
avec :

Le signal PWM est généré à partir des entrées de la table :

| ENTREES | | | | SORTIE | |
|---|---|---|---|---|---|
| Set | Clear | set_or_clear | rebouclage_PWM | Sortie PWM | |
| 0 | 0 | 0 | 0 | **0** | |
| 0 | 0 | 0 | 1 | **1** | |
| 0 | 0 | 1 | 0 | **0** | |
| 0 | 0 | 1 | 1 | **1** | |
| 0 | 1 | 0 | 0 | **0** | |
| 0 | 1 | 0 | 1 | | |
| 0 | 1 | 1 | 0 | | |
| 0 | 1 | 1 | 1 | | |
| 1 | 0 | 0 | 0 | **1** | |
| 1 | 0 | 0 | 1 | | |
| 1 | 0 | 1 | 0 | | |
| 1 | 0 | 1 | 1 | | |
| 1 | 1 | 0 | 0 | **0** | |
| 1 | 1 | 0 | 1 | | |
| 1 | 1 | 1 | 0 | **1** | |
| 1 | 1 | 1 | 1 | | |

Le signal complémentaire PWM_N est généré à partir des entrées de la table :

| ENTREES | | | | SORTIE | |
|---|---|---|---|---|---|
| Set | Clear | set_or_clear | rebouclage_PWM | Sortie PWM | |
| 0 | 0 | 0 | 0 | **0** | |
| 0 | 0 | 0 | 1 | **1** | |
| 0 | 0 | 1 | 0 | **0** | |
| 0 | 0 | 1 | 1 | **1** | |

(suite)

| ENTREES | | | | SORTIE | |
|---|---|---|---|---|---|
| **Set** | **Clear** | **set_or_clear** | **rebouclage_PWM** | **Sortie PWM** | |
| 0 | 1 | 0 | 0 | | |
| 0 | 1 | 0 | 1 | **1** | |
| 0 | 1 | 1 | 0 | | |
| 0 | 1 | 1 | 1 | | |
| 1 | 0 | 0 | 0 | | |
| 1 | 0 | 0 | 1 | **0** | |
| 1 | 0 | 1 | 0 | | |
| 1 | 0 | 1 | 1 | | |
| 1 | 1 | 0 | 0 | **1** | |
| 1 | 1 | 0 | 1 | | |
| 1 | 1 | 1 | 0 | **0** | |
| 1 | 1 | 1 | 1 | | |

**7.** - Architecture émettrice de signaux RF selon l'une des revendications précédentes **caractérisée en ce qu'**elle comporte en plus une ou plusieurs lignes de retards temporels (45) afin d'augmenter la résolution temporelle du signal PWM.

**Patentansprüche**

**1.** Übertragungsarchitektur für Hochfrequenz- bzw. HF-Signale, umfassend mindestens eine Schaltzelle (22), die von einem ersten Pulsdauermodulations- bzw. PWM-Signal $S_1$ und einem zweiten Pulsdauermodulations- bzw. PWM_N-Signal $S_2$, das zum ersten komplementär ist, gesteuert wird, aufweisend mindestens die folgenden Elemente:

die Schaltzelle (22) ist aus einer ersten, oberen Schaltzelle (61) und einer zweiten, unteren Schaltzelle (62) zusammengesetzt, wobei die erste und die zweite Zelle in einer Halbbrücke montiert und mit einem Mittelpunkt M verbunden sind,
die erste, obere Schaltzelle (61) ist dafür konfiguriert, an einem ihrer Eingänge das erste Signal $S_1$ zu empfangen,
die zweite, untere Schaltzelle ist dafür konfiguriert, an einem ihrer Eingänge das zum Signal $S_1$ komplementäre Signal $S_2$ zu empfangen,
die Signale $S_1$ und $S_2$ sind komplementär, so dass eine einzelne der beiden Zellen durchgängig ist, während die andere blockiert ist,
eine Stromversorgungsvorrichtung (23) ist dafür konfiguriert, einen ersten Stromversorgungswert $V_{dd1}$ für die obere Zelle (61) und einen zweiten Stromversorgungswert $V_{dd2}$ für die untere Zelle (62) bereitzustellen, und **dadurch gekennzeichnet, dass** sie mindestens Folgendes umfasst:

eine Vorrichtung (21) zum Erzeugen der beiden Steuersignale der Zelle,
wobei eine erste Vorrichtung zum Erzeugen des ersten Signals $S_1$ mindestens Folgendes umfasst:

• einen ersten Eingang (41) für ein Set-Signal zum Einstellen ihres Ausgangs $S_1$ auf "1",
• einen zweiten Eingang (42) für ein Reset-Signal zum Rückstellen ihres Ausgangs $S_1$ auf "0",
• einen dritten Eingang (43) für ein Set_or_Clear-Signal, das derart ausgewählt ist, dass der Ausgang $S_1$ einen stabilen Wert aufweist, wenn das Set-Signal und das Reset-Signal in verbotenen Zuständen positioniert sind,
• einen vierten Eingang (44), der ein Bild des Ausgangs der Vorrichtung zum Erzeugen des Signals $S_1$ ist,

wobei eine zweite Vorrichtung zum Erzeugen des zweiten Signals $S_2$ mindestens Folgendes umfasst:

einen ersten Eingang (41) für ein Set-Signal zum Einstellen ihres Ausgangs $S_2$ auf "1",
einen zweiten Eingang (42) für ein Reset-Signal zum Rückstellen ihres Ausgangs $S_2$ auf "0",
einen dritten Eingang (43) für ein Set_or_Clear-Signal, das derart ausgewählt ist, dass der Ausgang $S_2$ einen stabilen Wert aufweist, der gleich dem Kehrwert des Signalwertes am Ausgang der ersten Vorrichtung ist, die das Signal $S_1$ erzeugt, wenn das Set-Signal und das Reset-Signal in verbotenen Zuständen platziert sind,
einen vierten Eingang (44), der ein Bild des Ausgangs der zweiten Vorrichtung zum Erzeugen des Signals $S_2$ ist.

2. Übertragungsarchitektur für HF-Signale nach Anspruch 1, **dadurch gekennzeichnet, dass** sie des Weiteren eine Anpassungsvorrichtung (26) umfasst, die sich am Eingang der Schaltzelle befindet, um die beiden komplementären Signale anzupassen.

3. Übertragungsarchitektur für HF-Signale nach einem der Ansprüche 1 oder 2, **dadurch gekennzeichnet, dass** der Spannungswert $V_{dd2}$ kleiner als $V_{dd1}$ ist.

4. Übertragungsarchitektur für HF-Signale nach einem der Ansprüche 1 oder 2, **dadurch gekennzeichnet, dass** der Spannungswert $V_{dd2}$ gleich Null ist.

5. Übertragungsarchitektur für HF-Signale nach einem der Ansprüche 1 oder 2, **dadurch gekennzeichnet, dass** die Vorrichtung (21) zum Erzeugen der Steuersignale in einem feldprogrammierbaren Gate-Array FPGA verwirklicht ist.

6. Übertragungsarchitektur für HF-Signale nach Anspruch 5, **dadurch gekennzeichnet, dass** die integrierte Halbleiterschaltung eine Verweistabelle mit vier Eingängen umfasst, die jeweils die folgenden Rollen haben:

ein "Set"-Signal ermöglicht das Setzen des Ausgangs/ PWM-Signals auf "1", ;
ein "Clear-"Signal ermöglicht das Setzen des Ausgangs oder des PWM-Signals auf "0", oder;
ein "Set_or_Clear"-Signal ermöglicht das Bestimmen der "Dominanz" des "Set"-Signals oder des "Clear"-Signals in dem Fall, in dem diese beiden Signale gleichzeitig auf "1" stehen,
eine Rückschleife des PWM-Ausgangs, um seinen vorherigen Zustand zu behalten in dem Fall, in dem das "Set"-Signal oder das "Clear"-Signal auf 0 steht,
die Verweistabelle dafür konfiguriert ist, das PWM-Signal und das komplementäre PWM_N-Signal zu erzeugen, wobei:

das PWM-Signal anhand der Eingänge der Tabelle erzeugt wird:

| EINGÄNGE | | | | AUSGANG |
|---|---|---|---|---|
| Set | Clear | Set_or_Clear | Rückschleife_PWM | PWM-Ausgang |
| 0 | 0 | 0 | 0 | **0** |
| 0 | 0 | 0 | 1 | **1** |
| 0 | 0 | 1 | 0 | **0** |
| 0 | 0 | 1 | 1 | **1** |
| 0 | 1 | 0 | 0 | **0** |
| 0 | 1 | 0 | 1 |  |
| 0 | 1 | 1 | 0 |  |
| 0 | 1 | 1 | 1 |  |
| 1 | 0 | 0 | 0 |  |
| 1 | 0 | 0 | 1 | **1** |
| 1 | 0 | 1 | 0 |  |
| 1 | 0 | 1 | 1 |  |

(fortgesetzt)

| EINGÄNGE | | | | AUSGANG |
|---|---|---|---|---|
| **Set** | **Clear** | **Set_or_Clear** | **Rückschleife_PWM** | **PWM-Ausgang** |
| 1 | 1 | 0 | 0 | **0** |
| 1 | 1 | 0 | 1 | |
| 1 | 1 | 1 | 0 | **1** |
| 1 | 1 | 1 | 1 | |

das komplementäre PWM_N-Signal anhand der Eingänge der Tabelle erzeugt wird:

| EINGÄNGE | | | | AUSGANG | |
|---|---|---|---|---|---|
| **Set** | **Clear** | **Set_or_Clear** | **Rückschleife_PWM** | **PWM-Ausgang** | |
| 0 | 0 | 0 | 0 | **0** | |
| 0 | 0 | 0 | 1 | **1** | |
| 0 | 0 | 1 | 0 | **0** | |
| 0 | 0 | 1 | 1 | **1** | |
| 0 | 1 | 0 | 0 | **1** | |
| 0 | 1 | 0 | 1 | | |
| 0 | 1 | 1 | 0 | | |
| 0 | 1 | 1 | 1 | | |
| 1 | 0 | 0 | 0 | **0** | |
| 1 | 0 | 0 | 1 | | |
| 1 | 0 | 1 | 0 | | |
| 1 | 0 | 1 | 1 | | |
| 1 | 1 | 0 | 0 | **1** | |
| 1 | 1 | 0 | 1 | | |
| 1 | 1 | 1 | 0 | **0** | |
| 1 | 1 | 1 | 1 | | |

**7.** Übertragungsarchitektur für HF-Signale nach einem der vorhergehenden Ansprüche, **dadurch gekennzeichnet, dass** sie des Weiteren eine oder mehr Zeitverzögerungsleitungen (45) umfasst, um die Zeitauflösung des PWM-Signals zu erhöhen.

**Claims**

**1.** An architecture for transmitting radiofrequency RF signals, having at least one switching cell (22) controlled by a first pulse-width modulation PWM signal $S_1$ and a second pulse-width modulation PWM_N signal $S_2$ that is complementary to the first, having at least the following elements:

the switching cell (22) is composed of a first, top switching cell (61) and of a second, bottom switching cell (62), said first and second cells being mounted in a halfbridge and connected to a midpoint M,
the first, top switching cell (61) is configured to receive, over one of its inputs, the first signal $S_1$,
the second, bottom switching cell is configured to receive, over one of its inputs, the signal $S_2$ that is complementary to the signal $S_1$,

the signals $S_1$ and $S_2$ are complementary so that only one of the two cells is switched on while the other is off, a power supply device (23) is configured to deliver a first power supply value $V_{dd1}$ for the top cell (61) and a second power supply value $V_{dd2}$ for the bottom cell (62), and
**characterised in that** it has at least:

> a device (21) for generating the two signals for controlling the cell,
> a first device for generating the first signal $S_1$, comprising at least:
>
> > • a first input (41) for a set signal for setting its output $S_1$ to "1",
> > • a second input (42) for a reset signal for resetting its output $S_1$ to "0",
> > • a third input (43) for a set_or_clear signal, chosen such that the value of the output $S_1$ is stable when the set signal and the reset signal are placed in forbidden states,
> > • a fourth input (44) that is an image of the output of the device for generating the signal $S_1$,
>
> a second device for generating the second signal $S_2$, comprising at least:
>
> > • a first input (41) for a set signal for setting its output $S_2$ to "1",
> > • a second input (42) for a reset signal for resetting its output $S_2$ to "0",
> > • a third input (43) for a set_or_clear signal, chosen such that the value of the output $S_2$ is stable and equal to the inverse of the value of the signal at the output of the first device generating the signal $S_1$ when the set signal and the reset signal are placed in forbidden states,
> > • a fourth input (44) that is an image of the output of the second device for generating the signal $S_2$.

2. The architecture for transmitting RF signals according to claim 1, **characterised in that** it further has an adjusting device (26) located at the input of the switching cell so as to adjust the two complementary signals.

3. The architecture for transmitting RF signals according to one of claims 1 or 2, **characterised in that** the value of the voltage $V_{dd2}$ is lower than $V_{dd1}$.

4. The architecture for transmitting RF signals according to one of claims 1 or 2, **characterised in that** the value of the voltage $V_{dd2}$ is equal to zero.

5. The architecture for transmitting RF signals according to one of claims 1 or 2, **characterised in that** the device (21) for generating the control signals is produced in a field-programmable gate array FPGA.

6. The architecture for transmitting RF signals according to claim 5, **characterised in that** the field-programmable gate array comprises a lookup table with four inputs having the following respective roles:

> a "set" signal allows the output/the PWM signal to be set to "1";
> a "clear" signal allows the output or the PWM signal to be set to "0";
> a "set_or_clear" signal allows the "dominance" of the "set" signal or of the "clear" signal to be determined in the case of these two signals being "1" at the same time;
> a loopback from the PWM output so as to retain its preceding state in the case of the "set" or "clear" signals being 0;
> the lookup table is configured to generate the PWM signal and the complementary PWM_N signal, where:
>
> the PWM signal is generated from the inputs in the table:

| INPUTS | | | | OUTPUT |
|---|---|---|---|---|
| Set | Clear | set_or_clear | PWM_loopback | PWM output |
| 0 | 0 | 0 | 0 | **0** |
| 0 | 0 | 0 | 1 | **1** |
| 0 | 0 | 1 | 0 | **0** |
| 0 | 0 | 1 | 1 | **1** |

(continued)

| INPUTS | | | | OUTPUT |
|---|---|---|---|---|
| Set | Clear | set_or_clear | PWM_loopback | PWM output |
| 0 | 1 | 0 | 0 | **0** |
| 0 | 1 | 0 | 1 | |
| 0 | 1 | 1 | 0 | |
| 0 | 1 | 1 | 1 | |
| 1 | 0 | 0 | 0 | **1** |
| 1 | 0 | 0 | 1 | |
| 1 | 0 | 1 | 0 | |
| 1 | 0 | 1 | 1 | |
| 1 | 1 | 0 | 0 | **0** |
| 1 | 1 | 0 | 1 | |
| 1 | 1 | 1 | 0 | **1** |
| 1 | 1 | 1 | 1 | |

the complementary PWM_N signal is generated from the inputs in the table:

| INPUTS | | | | OUTPUT | |
|---|---|---|---|---|---|
| Set | Clear | set_or_clear | PWM_loopback | PWM output | |
| 0 | 0 | 0 | 0 | **0** | |
| 0 | 0 | 0 | 1 | **1** | |
| 0 | 0 | 1 | 0 | **0** | |
| 0 | 0 | 1 | 1 | **1** | |
| 0 | 1 | 0 | 0 | **1** | |
| 0 | 1 | 0 | 1 | | |
| 0 | 1 | 1 | 0 | | |
| 0 | 1 | 1 | 1 | | |
| 1 | 0 | 0 | 0 | **0** | |
| 1 | 0 | 0 | 1 | | |
| 1 | 0 | 1 | 0 | | |
| 1 | 0 | 1 | 1 | | |
| 1 | 1 | 0 | 0 | **1** | |
| 1 | 1 | 0 | 1 | | |
| 1 | 1 | 1 | 0 | **0** | |
| 1 | 1 | 1 | 1 | | |

7. The architecture for transmitting RF signals according to one of the preceding claims, **characterised in that** it further has one or more time delay lines (45) so as to increase the temporal resolution of the PWM signal.

FIG.1

EP 3 824 549 B1

EP 3 824 549 B1

FIG.2

FIG.3

FIG.4

FIG.5

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017230017 A
- EP 2670101 A
- WO 2008051127 A
- EP 3134972 A